# EUROPÄISCHE PATENTSCHRIFT

(11) **EP 1 212 786 B1**
(45) Veröffentlichungstag und Bekanntmachung des Hinweises auf die Patenterteilung: **26.09.2012**
(21) Anmeldenummer: 00958187.7
(22) Anmeldetag: 28.07.2000
(51) Int. Cl.: H01L 21/205, H01L 21/331

(54) **SCHICHTSTRUKTUR FÜR BIPOLARE TRANSISTOREN UND VERFAHREN ZU DEREN HERSTELLUNG**
LAYER STRUCTURE FOR BIPOLAR TRANSISTORS AND METHOD FOR THE PRODUCTION THEREOF
STRUCTURE STRATIFIEE POUR TRANSISTORS BIPOLAIRES ET SON PROCEDE DE FABRICATION

(30) Priorität: 26.08.1999 DE 19940278
(43) Veröffentlichungstag der Anmeldung: 12.06.2002
(73) Patentinhaber: IHP GmbH-Innovations for High Performance Microelectronics / Leibniz-Institut für innovative Mikroelektronik, 15236 Frankfurt / Oder (DE)
(72) Erfinder: KRÜGER, Dietmar, D-15236 Frankfurt (Oder) (DE); MORGENSTERN, Thomas, D-15236 Frankfurt (Oder) (DE); EHWALD, Karl-Ernst, D-15234 Frankfurt (Oder) (DE); BUGIEL, Eberhard, D-15230 Frankfurt (DE); HEINEMANN, Bernd, D-15234 Frankfurt (Oder) (DE); KNOLL, Dieter, D-15230 Frankfurt (Oder) (DE); TILLACK, Bernd, D-15234 Frankfurt (Oder) (DE)
(74) Vertreter: Eisenführ, Speiser & Partner
(86) Internationale Anmeldenummer: PCT/DE2000/002491
(87) Internationale Veröffentlichungsnummer: WO 2001/017002

(56) Entgegenhaltungen:
- WO-A-98/26457
- US-A- 4 563 807
- WEIR B E ET AL: "LOW-TEMPERATURE HOMOEPITAXY ON SI(111)" APPLIED PHYSICS LETTERS,US,AMERICAN INSTITUTE OF PHYSICS. NEW YORK, Bd. 59, Nr. 2, 8. Juli 1991 (1991-07-08), Seiten 204-206, XP000230501 ISSN: 0003-6951
- HAMEL J S ET AL: "Trade-off between emitter resistance and current gain in polysilicon emitter bipolar transistors with intentionally grown interfacial oxide layers" IEEE ELECTRON DEVICE LETTERS, JUNE 1992, USA, Bd. 13, Nr. 6, Seiten 332-334, XP002156027 ISSN: 0741-3106 in der Anmeldung erwähnt
- LIPPERT G ET AL: "Optimized processing for differentially molecular beam epitaxy-grown SiGe(C) devices" PREPARATION AND CHARACTERIZATION,NL,ELSEVIER SEQUOIA, Bd. 321, Nr. 1-2, 26. Mai 1998 (1998-05-26), Seiten 21-25, XP004147888 ISSN: 0040-6090
- ABDUL-RAHIM A I ET AL: "Improved control of polysilicon emitter interfacial oxide using a UHV-compatible LPCVD cluster tool" IEEE MTT/ED/AP/LEO SOCIETIES JOINT CHAPTER UNITED KINGDOM AND REPUBLIC OF IRELAND SECTION. 1997 WORKSHOP ON HIGH PERFORMANCE ELECTRON DEVICES FOR MICROWAVE AND OPTOELECTRONIC APPLICATIONS. EDMO (CAT. NO.97TH8305), IEEE MTT/ED/AP/LEO SOCIETIES JOINT C, Seiten 232-236, XP002156028 1997, New York, NY, USA, IEEE, USA ISBN: 0-7803-4135-X
- AGNELLO P D ET AL: "CONDITIONS FOR AN OXIDE-FREE SI SURFACE FOR LOW-TEMPERATURE PROCESSING: STEADY-STATE BOUNDARY" JOURNAL OF THE ELECTROCHEMICAL SOCIETY,US,ELECTROCHEMICAL SOCIETY. MANCHESTER, NEW HAMPSHIRE, Bd. 139, Nr. 10, 1. Oktober 1992 (1992-10-01), Seiten 2929-2934, XP000359004 ISSN: 0013-4651 in der Anmeldung erwähnt

## Beschreibung

Die Erfindung betrifft ein Verfahren zur Herstellung einer Schichtstruktur für bipolare Transistoren

Halbleiternaterialien, wie Silizium, Silizium-Germanium, Galliumarsenid, Galliumphosphid werden in großem Maße für die Herstellung von Halbleitervorrichtungen verwendet. Wichtige Vorteile moderner Bipolartransistoren, beispielsweise auf der Basis von Siₓ₋Ge_{y}C_{1-x-y} Heterostrukturen, mit den Parametern x,y im Bereich 0 ≤ x,y ≤ 1, liegen u.a in ihrer extremen Schnelligkeit, ihren geringen Basiswiderständen und einem verbesserten Rauschverhalten. Gleichzeitig ist die Technologie zur Herstellung integrierter Schaltkreise unter Nutzung von SiₓGe_{y}C_{1-x-y} / Si HBT's kompatibel mit der weit etablierten Massentechnologie für integrierte Schaltkreise auf Siliziumbasis, Die aufgeführten Vorteile machen schnelle Transistoren auf der Basis von SiₓGe_{y}C_{1-x-y}-Schichtstrukturen zu einer Vorzugsvariante fur hochintegrierte Schaltkreise mit dem Einsatz in der modernen Telekommunilcation.

Der Fortschritt der modernen Halbleitertechnologie für die Produktion hochintegrierter Schaltkreise hängt bereits heute wesentlich von der Herstellung extrem kleiner elektrisch aktiver Bereiche und extrem flacher und steiler Übergänge ab. Die entsprechenden Anforderungen an die Technologie wurden in der Vergangenheit gut durch die "Si Roadmap" (National Technology Roadmap Semiconductors, Semiconductor Industries Association 1997) der Siliziummikroelektronik beschrieben. Danach sind für fortgeschrittene, hochintegrierte Schaltkreise Übergangstiefen von 50 - 120 nm gefordert, die in nächster Zukunft weiter verringert werden müssen, um mit der absehbaren lateralen Skalierung Schritt zu halten. Fortgeschrittene Heterostrukturen auf Basis von SiₓGe_{y}C_{1-x-y} - Schichten nutzen Ernittereindringtiefen in das Silizium von kleiner als 30 nm. Die Basis der Transistorstruktur wird aus SiₓGe_{y}C₁₋ₓ₋y, SiₓGe₁₋ₓ-Schichten mit Dicken von zum Teil unter 20 nm gebildet. Die Perfektion der gewachsenen epitaktischen Schichten und der bei der Schichtabscheidung entstehenden Grenzflächen ist eine Voraussetzung für eine hohe Ausbeute an guten Transistoren und Schaltkreisen und für das fehlerfreie Funktionieren der entsprechenden Schaltkreise.

Die Problematik von Poly-Si-Emitterschichten auf Silizium für die Herstellung von Bipolartransistoren wurde in jüngster Zeit verstärkt untersucht. Dabei wurden zur Erzielung einer ausreichenden Stromverstärkung bei der Herstellung der Vertikalstrukturen Sauerstoff-kontaminierte Grenzflächen mit erhöhten Emitterwiderständen in Kauf genommen [J. S. Hamel, D. J. Roulston, C. R. Selvakumar, IEEE Electron Device Letters, 13 (6), 332 (1992)]. Gleichzeitig wird in dieser Arbeit der Nachteil der starken Prozeßabhängigkeit der elektrischen Parameter, bedingt durch die nicht ausreichende Kontollierbarkeit der Grenzflächenkontamination und die Inhomogenität der Grenzflächendurchbrüche bei nachfolgenden Temperungen aufgezeigt. Es ist weiterhin bekannt, daß Transistoren mit kontaminierten Grenzflächen den Nachteil schlechterer Rauschparameter haben. Für moderne bipolare Heterostrukturen, wie sie auf Basis von Si / Si /SiₓGe_{y}C_{1-x-y} / Si - Schichtfolgen realisiert werden, ist eine ausreichende Stromverstärkung über die Bandstruktur der Basisschicht in weiten Grenzen einstellbar, so daß nach Lösungen zu suchen ist, wie die Emitterwiderstände und das Rauschen verringert werden können. Die den Emitter und Emitteranschluß formierende Si-Schicht ist nach dem Stand der Technik sowohl für Silizium, Si-Homostrukturen als auch in Si / Si / SiₓGe_{y}C_{1-x-y} / Si - Heterostrukturen als eine polykristalline Si-Schicht ausgebildet, wie in vielen Publikationen beschrieben [beispielsweise in J. D. Cressler, IEEE Electron Device Lett., 17, 13 (1996), D. Knoll u.a., IEDM Techn. Dig., 703 (1998)]

Die damit verbundenen Nachteil, wie verschlechtertes Eindiffusionsverhalten der Dotanden, erhöhte Oberflächenrauhigkeit des Emitters u.a., werden im Stand der Technik in Kauf genommen, obwohl sie zu verschlechterten elektrischen Parametern führen, da eine Verbesserung der Grenzflächeneigenschaften bisher mit hohem technologischem und finanziellem Aufwand verbunden ist.

Für die Absicherung des epitaktischen Wachstums sind extrem saubere Grenzflächen und Wachstumsbedingungen erforderlich. Derartig saubere Grenzflächen werden beispielsweise in Ultrahochvakuum-Systemen für die Molekularstrahlepitaxie (MBE) sowie in extrem sauberen Normaldruck- und Niederdruck-Anlagen für die Abscheidung aus der chemischen Gasphase (CVD) ermöglicht. Für die Reinigung der Oberfläche wird ein Desorbtionsschritt für Sauerstoff in der Regel im Temperaturbereich oberhalb 1000 °C genutzt. Hohe Desorbtionstemperaturen sind jedoch für vorprozessierte Wafer, in denen bereits Dotierungsprofile eingestellt sind, nicht einsetzbar, da sie die eingestellten Dotierungsprofile unzulässig verändern. In der Literatur ist eine Reihe von Veröffentlichungen bekannt, die diesem Problem gewidmet sind. So werden in der Arbeit von D. Agnello, und T.O. Sedgewick [D. Agnello, und T.O. Sedgewick, Journal Electrochemical Society, 139 (19), 2929 (1992)] die Bedingungen für oxidfreie Si-Oberflächen bei UHV-CVD Prozessen abgeleitet und gezeigt, wie die Existenz von Sauerstoffrestkontaminationen zur Generation von Zwillingsdefekten und Stapelfehlern führt. Die Bedingungen für epitaktisches Wachstum im Falle der UHV - CVD sind weniger streng als bei der MBE. Dennoch muß bei der UHV-CVD der Sauerstoffpartialdruck im Trägergas bei 700 °C kleiner als ca. 1 ppb sein, um defektfreies Wachstum zu ermöglichen. Bei der UHV - MBE werden Sauerstoffpartialdrücke von kleiner ca. 2 x 10⁻⁹ Torr bei 700 °C für defektfreies Wachsturn gefordert.

In der Arbeit von Niel und anderen (S. Niel, O. Rozeau, und andere, Techn. Digest. IEDM, p. 807 (1997)] wird von der Formierung eines einkristallinen Emitters bei As in-situ Dotierung in einem kommerziellen Einscheibenreaktor berichte. Diese technische Lösung hat jedoch den wesentlichen Nachteil einer geringen Produktivität, vor allem bedingt durch den Einsaheibenreaktor selbst. Zum anderen müssen für die Absicherung des einkristallinen Wachstums und für ausreichende Wachsturnsgeschwindigkeiten relativ hohe Wachsturnstemperaturen eingesetzt werden, was für Wafer mit begrenztem zulässigem Wärmebudget ein wesentlicher Nachteil sein kann.

Es ist weiter bekannt, daß komplett epitaktische Vertikalstrukturen für bipolare Transistoren in Ultrahochvakuum-Systemen für die Molekularstrahlepitaxie (MBE) sowie in extrem sauberen Normaldruck- und Niederdruck-CVD-Anlagen ohne Wachstumsunterbrechung hergestellt werden können. Dabei entfällt jedoch die Möglichkeit, nach Herstellung der Kollektor- und Basis-Gebiete externe Präparationsschritte außerhalb des Epitaxiereaktors durchführen zu können. Dies schränkt die technologischen Möglichkeiten der Einbindung der Transistoren in komplexe Schaltungen in erheblichem Maße ein.

Der Erfindung liegt die Aufgabe zugrunde, ein Verfahren zu Herstellung einer Schichtstruktur für bipolare Transistoren vorzuschlagen, mit Hilfe derer die elektrischen Eigenschaften und die Homogenität bipolarer Transistoren verbessert werden. Insbesondere soll bei verringerten Emitterübergangswiderständen das Basisstromverhalten verbessert und das Rauschen reduziert werden,

Aus dem Dokument Abdul-Rahim A1 et al. Improved control of polysilicon emitter interfacial oxide using a UHV-compatible LPCVD cluster tool" IEEE MTT/ED/AP/LEO Societies Joint Chapter United Kingdom and Republic of Ireland Section, 1997 Workshop on High Performance Electron Devices for Microwave and Optoelectronic Applications, EDMO(CAT. No.97TH8305), IEEE MTT/ED/AP/LEO Societies Joint C, Seiten 232 - 236, 1997, New York, NY, USA, IEEE, USA ist eine Emitter-Schichtstruktur für Si-basierende Bipolartransistoren bekannt. Diese Strukturen weisen dünne Oxidschichten auf. Abhängig von der Dicke der Oxidschicht liegt über der Oxidschicht entweder eine einkristalline Emitterschicht oder eine polykristalline Emitterschicht vor. Dabei entsteht die einkristalline Emitterschicht während einer dreißig-sekündigen Wärmebehandlung, dem Emitter-Drive-In, aus dem polykristallinen Silizium durch Rekristalüsation, wenn die Oxidschicht dünn genug ist. Diese Rekristallisation setzt sich bei den Temperaturen des Drive-In von der Oxidschicht ausgehend bis zur Oberfläche der Emitterschicht fort. Aufgabe der Erfindung ist es, eine Emitterschicht mit einer anderen Struktur zu schaffen, die vorteilhaft in Silizium-Bipolartransistoren einsetzt werden kann.

Das Dokument Weir B. E. et al. Low-Temperature Homoepitaxy on Si(111)" Applied Phvsics Letters. US American Institute of Physics, New York, Bd. 59, Nr. 2,8. Juli 1991 (1991-07-08). Seiten 204-206, sind Simulationsrechnungen zur Molekulardynamik des epitaktischen Wachstums bekannt. Die Simulationen zeigen eine Temperaturabhängigkeit eines Bruchteils fehlpositionierter Atome an einer Wachsturnsoberfläche einer epitaktisch aufwachsenden Siliziumschicht. Demnach erfolgt das Wachstum bei sehr niedrigen Temperaturen unterhalb einer Übergagstemperatur im wesentlichen amorph. Oberhalb der Überganpstemperatur nimmt der Bruchteil epitaktisch wachsender Schichtteile dramatisch zu. und es sollmöglich werden, integrierte Schaltungen mit derartigen bipolaren Transistoren bei guter Ausbeute und Reproduzierbarkeit herzustellen.

Die sohergestellte Vertikalstruktur der Transistoren enthält eine partiell-einkristalline Emitterschicht, die oberhalb einer epitaktischen, einkristallinen Anwachsschicht in eine polykristalline und/oder amorphe Schicht umschlägt und in der Vertikalstruktur des Transistors die partiell-einkristalline Emitterschicht lokal mit dünnen Oxid- und/oder Nitridschichten unterlegt ist. Die partiell-einkristalline Emitterschicht ist auf einer SiₓGe_{y}C_{1-x-y}-Deckelschicht, einer Si-Pufferschicht und einem Silizium-Substrat mit den Parametern x,y im Bereich 0 ≤ x,y ≤ I abgeschieden. Die Grenzfläche zwischen der partiell-einkristallinen Emitterschicht und dem Unterbau ist durch eine geringe Sauerstoffkontamination mit einer Sauerstoffdosis kleiner als 1 x 10¹⁵ cm⁻² gekennzeichnet. Mindestens ein Teil der elektrisch aktiven Zone der partiell-einlaistallinen Emitterschicht ist durch eine SiₓGe_{y}C_{1-x-y}-Deckelschicht mit den Parametern x,y im Bereich 0 ≤ x,y ≤ 1 gebildet. Das erfindungsgemäße Verfahren zur Herstellung der Schichtstruktur für Si-basierende bipolare Transistoren beruht darauf, dass
- eine Lagerung der Proben nach einer Vorbehandlung der Oberfläche des Siliziumsubstrats mit Hydrofluorid-haltigen Lösungsmitteln und vor dem Einschleusen in einen CVD-Reaktor auf weniger als eine Stunde begrenzt wird,
- eine Vortemperung der Proben im Temperaturbereich von 650 °C -1100 °C in wasserstoffhaltigen Gasen bei Temperzeiten im Bereich von 5 Sekunden bis 120 Minuten vorgesehen ist,
- ein Dotiergas bereits während der Abkühlung auf die Schichtwachstumstemperatur zugeführt wird und daß
- nach einer Abkühlung auf die Schichtwachstumstemperatur eine partiell-einkristalline Emitterschicht (5) unter Zugabe von Silan und Dotiergas bei einer Temperatur im Bereich 450 - 700 °C aufgebracht wird, die zunächst einkristallin anwächst und dann in eine polykristalline und/oder amorphe Schicht umschlägt.

Vorteilhafterweise wird die partiell-einkristalline Emitterschicht mittels chemischer Gasphasenabscheidung bei Niederdruck in einem Vielscheibenreaktor aufgebracht. Bevorzugt wird die partiell-einkristalline Emitterschicht durch eine dotierte SiₓGe_{y}C_{1-x-y}-Schicht mit den Parametern x,y im Bereich 0 ≤ x,y ≤ 1 gebildet. Die Proben werden ohne eine Belüftung der CVD-Anlage vor der Vortemperung in wasserstoffhaltigen Gasen einer intensiven Stickstoffspülung von mindestens 15 Minuten bei kaltem CVD-Reaktor unterzogen. Der Schichtaufbau wird nach der Formierung der Si-Deckelschicht und vor dem Abscheiden der partiell-einkristallinen Emitterschicht weiteren technologischen Teilschritten, wie beispielsweise Oxidationen, Implantationen, Ätzungen, Maskenteilschritte, unterzogen. Das Dotierungselement für die partiell-einkristalline Emitterschicht ist As und/oder P. Zum Aufwachsen der Emitterschicht wird mindestens ein Emitterdotand während des CVD Abscheideprozesses eingebracht. Vorteilhafterweise wird der Emitterdotand bereits beim Abkühlungsprozeß und vor der Silanzugabe zum Aufwachsen der partiell-einkristallinen Emitterschicht eingebracht. Wahlweise werden eine homogen dotierte partiell-einkristalline Emitterterschicht oder zur Erhöhung der Wachstumsrate dotierte und undotierte Bereiche der partiell-einkristallinen Emitterschicht im Wechsel abgeschieden. In einer bevorzugten Ausführung wird die partiell-einkristalline Emitterschicht auf Si-Substratwafern aufgebracht. In einer ebenfalls bevorzugten Ausführung vvird die partiell-kristalline Emitterschicht auf kommerziellen Si-Substratwafern oder auf kommerziellen "silicon-on-insulator" (SOI)-Wafern sowie Si-Wafern mit homoepitaktischen Schichten und entsprechend dem Stand der Technik formierten Si-Basisstrukturen und Si-Kollektorstrukturen aufgebracht. Bevorzugt kommt die partiell-einkristalline Emitterschicht in der Heterostruktur Si - Emitter / Si / Si_{y}C_{1-y} / Si- Substrat zum Einsatz. In einer anderen Ausführung kommt die partiell-kristalline Emitterschicht in dreikomponentigen Materialsystemen der Art Si - Emitter / Si / SiₓGe_{y}C_{1-x-y}, SiₓGe_{y}O_{1-x-y}, mit den Parametern x,y im Bereich 0≤x,y≤1, auf Si Substraten zum Einsatz.

In einer überraschenden und auch für den Fachmann nicht vorhersehbaren Art und Weise gelingt es dabei, in den Anfangsstadien sicher und homogen epitaktisches Wachstum zu stimulieren und damit vorteilhafte Grenzflächeneigenschaften zu erzeugen. Im nachfolgenden Prozeß wird durch Wahl der Abscheidebedingungen zu polykristallinen/amorphen Wachstumsbedingungen übergegangen und eine partiell-einkristalline Schichtfolge mit vorteilhaften Eigenschaften formiert.

Die Merkmale der Erfindung gehen außer aus den Ansprüchen auch aus der Beschreibung und der Zeichnung hervor, wobei die einzelnen Merkmale jeweils für sich allein oder zu mehreren in Form von Unterkombinationen schutzfähiger Ausführungen darstellen, für die hier Schutz beansprucht wird.

Ein Ausführungsbeispiel der Erfindung ist in der Zeichnung dargestellt und wird im folgenden näher erläutert. Es zeigen:
- Fig. 1(a)-1(c) -: schematische Schnittansichten eines Ausschnittes aus der Vertikalstruktur eines Bipolartransistors,
- **Fig.** 2(a), 2(b) -: analytische Meßergebnisse und eine Strukturdarstellung der erfindungsgemäßhergestellten partiell-einkristallinen Emitterschicht, die den Erfolg des Verfahrens illustrieren.

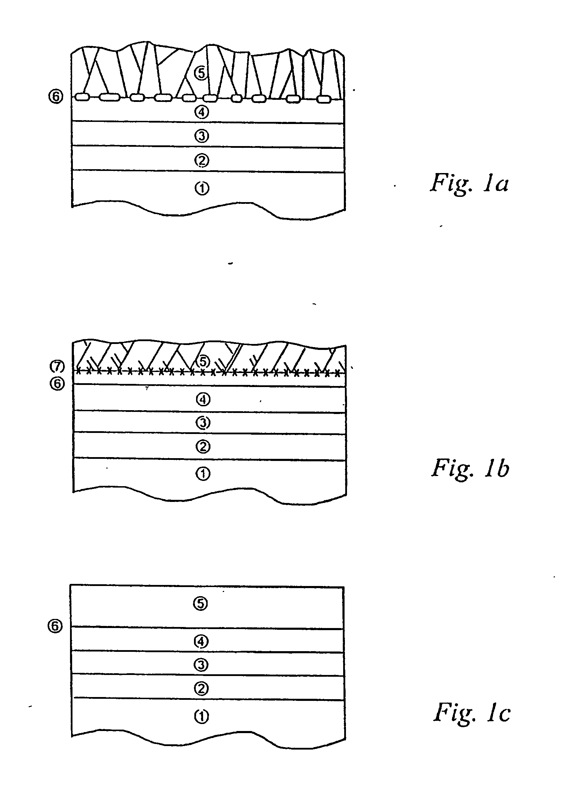

In Fig. 1a ist ein Siliziumwafer mit einem nach dem Stand der Technik erzeugten Schichtstapel für einen Heterobipolartransistor versehen. Der Schichtstapel besteht aus einer dotierten Si-Pufferschicht 2 unmittelbar auf dem Si-Substrat 1 zur Formierung des Kollektors, einer SiₓCe_{y}C_{1-x-y}-Schicht 3 mit den Parametern x,y im Bereich 0 ≤ x,y ≤ 1, zur Bildung der Basis, einer epitaktischen Si-Deckelschicht 4 und einer polykristallinen Siliziumschicht zur Formierung des Emitters 5 versehen. Die kritische Grenzfläche 6 zwischen der Si- Emitterschicht 5 und der epitaktischen Si-Deckelschicht 4 ist bei einer Schichtherstellung nach dem Stand der Technik mit Oxidresten und/oder starken Sauerstoffkontaminationen behaftet. Das führt zur Bildung einer Vielzahl von Wachstumskeimen, die letzlich polykristallines Schichtwachstum bedingen. Die polykristalline Emitterschicht kann auch durch eine SiₓGe₁₋ₓ-Schicht ausgebildet werden. Außerhalb des gezeigten Ausschnittes kann die Schichtabscheidung als polykristalline Schicht auch über entsprechend dem Stand der Technik erzeugten Nitrid- oder Oxidschichten oder über anderen Schichtaufbauten erfolgen.

Fig. 1b zeigt schematisch denselben, nach der erfindungsgemäßen Lösung erzeugten Schichtstapel, in dem die Grenzfläche 6 nur durch eine geringe Kontamination mit Sauerstoffkonzentrationen von vorzugsweise kleiner als 1 x 10¹⁵ cm⁻² gekennzeichnet ist und bei dem nach zunächst epitaktischem, einkristallinem Wachstum der Si-Emitterschicht 5 in späteren Wachstumsstadien kristallographische Defekte entstehen, die erst in einer deutlichen Entfernung mit Ausbildung einer weiteren Grenzfläche 7 in polykristallinem Wachstum der Si-Emitterschicht 5 enden.

Fig. 1c zeigt den nicht beanspruchten Grenzfall einer vollständig einkristallinen Emitterschicht 5, wie sie beispielsweise bei Wachstum in Ultrahochvakuum (UHV) Systemen für die Molekularstrahlepitaxie (MBE) oder bei hohen Temperaturen und/oder in extrem sauberen Normaldruck - und Niederdruck - CVD - Anlagen herstellbar ist.

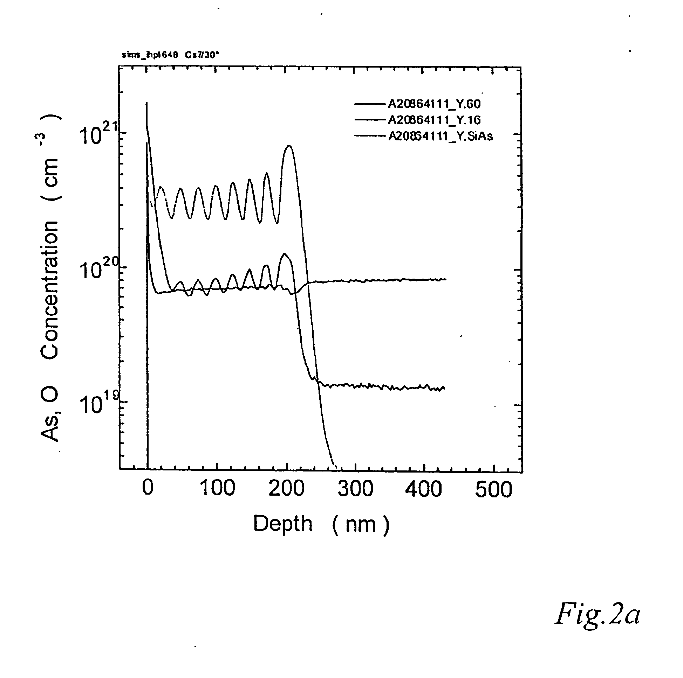

Fig. 2a liefert mittels Sekundärionenmassenspektroskopie (SIMS) aufgenommene quantifizierte Arsen- und Sauerstoff-Tiefenprofile einer partiell-einkristallinen Si-Emitterschicht 5 auf einem Si-Substrat 1 mit der Si-Deckelselücht 4 entsprechend dem erfindungsgemäßen Verfahren. Erkennbar ist die geringe Sauerstoffkontamination der Grenzfläche zwischen der As-dotierten partiell-einkristallinen Emitterschicht 5 und der Si-Deckelschicht 4 sowie die variierende As-Konzentration durch wechselweise dotiert und undotierte Abscheidung. Gleichzeitig wird ein für geringe Emitterübergangswiderstände erforderliches hohes As-Konzentrationsniveau gehalten.

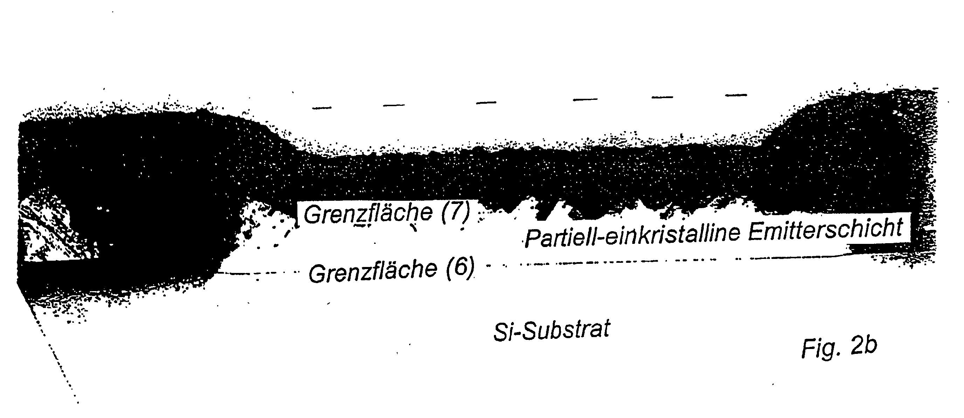

Fig. 2b zeigt in einer transmissionselektronenmikroskopischen Aufnahme eines Querschnittes durch die partiell-einkristalline Emitterschicht 5 mit den beiden Grenzflächen 6 und 7 den Erfolg des Verfahrens zur Herstellung von Transistoren mit einer partiell-einkristallinen Emitterschicht 5.

Für die erfindungsgemäße Herstellung der vertikalen Transistorstruktur kann eine kommerzielle, industriekompatible LP-CVD-Anlage mit einer großen Scheibenkapazität, beispielsweise von mehr als 50 Wafem pro Prozeß, ursprünglich spezifiziert für Abscheidungen von polykristallinem Silizium, eingesetzt werden. Dabei entsprechen sowohl die vorangehenden technologischen Schritte in der Transistorherstellung als auch die Lateralstruktur des Transistors dem Stand der Technik. Für die Herstellung der vertikalen Schichtfolge in der Transistorstruktur, insbesondere die Erzeugung der partiell-einkristallinen Emitterschicht 5, kommt das erfindungsgemäße Verfahren zur Anwendung. Vor der Einsteuerung der Wafer in die LP-CVD-Anlage erfolgt eine Waferreinigung auf der Grundlage hydrofluoridhaltiger Lösungsmittel. Die Lagerzeit der Proben nach der Ätzung wird ohne spezielle Oberfächenpassivierung auf weniger als eine Stunde begrenzt. Die erfindungsgemäße Lösung kann auch in CVD Anlagen ohne Waferschleuse, die die Belüftung der Gesamtanlage vermeidet, zum Einsatz kommen. In diesen Fällen wird die Anlage erfindungsgemäß einer intensiven Stickstoffspülung von mindestens 15 Minuten bei kaltem Reaktor unterzogen. Nach einer erfindungsgemäßen Vortemperung von 1 min bis mehreren Stunden, vorzugsweise von 30 Minuten, bei moderaten Temperaturen im Bereich von 550 °C bis 1100 °C, vorzugsweise bei 700 °C, unter Wasserstoff, kann erfindungsgemäß bereits bei der Abkühlung auf die Wachstumstemperatur im Bereich von 450 °C bis 700 °C, vorzugsweise 550 °C, die Zuschaltung des Dotiergases für die in-situ Dotierung der Schicht, vorzugsweise mit Arsen oder Phosphor, erfolgen. Bei Erreichen der Wachstumstemperatur erfolgt die Zugabe von Silan und der eigentliche Wachstumsprozeß setzt ein. Die Sauerstoffkontamination der Grenzfläche 6 zwischen der Emitterschicht 5 und dem Silizium-Substrat 1 beziehungsweise der Si-Deckelschicht 4 wird erfindungsgemäß auf eine eingebaute Sauerstoffdosis von kleiner als 5 x 10¹⁵ cm⁻², vorzugsweise kleiner als 1 x 10¹⁵ cm⁻², begrenzt. Wahlweise lassen sich homogen dotierte Schichten bei relativ geringer Wachstumsrate unter 0,1 nm/min oder dotiert/undotierte Bereiche mit moderaten Wachstumsraten oberhalb 1 nm/min bis mehrere 10 nm/min abscheiden.

Die Vorzüge des erfindungsgemäßen Verfahrens sind erkennbar. Durch die nahezu perfekte Grenzfläche 6 sind eine homogene Eindiffusion und ein geringer Übergangswiderstand möglich. Erkennbar ist in Fig. 2(b) auch die geringe Oberflächenrauhigkeit des Emitterkontaktes, die deutlich geringer ausfällt als bei entsprechend dem Stand der Technik erzeugten polykristallinen Emitterschichten mit großen Körnern.

Die erfindungsgemäße Lösung liefert darüber hinaus wesentliche weitere Vorteile:

Durch die Ausbildung wechselweise dotierter und undotierter Bereiche kann nach zunächst einkristallinem Anwachsen die Schichtabscheidung bei gleicher Schichtdicke wesentlich verkürzt werden. Das führt zu einer Verkürzung des gesamten technologischen Ablaufes. Durch die Abscheidung der in-situ dotierten Emitterschichten 5 können nachfolgende Implantationen zur Emitter-Dotierung eingespart werden.

Ein weiterer Vorteil der Erfindung liegt zusätzlich darin, daß durch das Fehlen der kontaminactionsbehafteten Grenzfläche die Eindiffusion des Dotanden homogenisiert wird, was sich ebenfalls in einer Verbesserung der elektrischen Parameter äußert.

Im Vergleich zu komplett einkristallinen Emitterschichten 5 besteht die Möglichkeit, zusätzliche Implantationen zu nutzen, ohne gravierend mit den für einkristalline Materialien typischen Effekten der implantationsinduzierten Nichtgleichgewichtsdiffusion, der sogenannten "transient-enhanced" Diffusion, konfrontiert zu sein.

Die erfindungsgemäße Lösung eröffnet die Möglichkeit, den Wachstumsprozeß mit einer selektiven, epitaktischen Abscheidung zu beginnen, wobei sich diese Schicht zunächst nur in den nicht mit Oxid bedeckten, geöffneten Fenstern abscheidet. Dabei wird der Höhenunterschied zwischen der Si-Oberfläche und der Oxidoberfläche vermindert. Erst beim Umschlag zum polykristallinen Silizium in den geöffneten Fenstern beginnt nichtselektives Schichtwachstum auf dem gesamten Wafer.

Die erfindungsgemäße Lösung ermöglicht auch die Schaffung einer entsprechenden Schichtsnuktur auf "silicon on insulator" (SOI)-Wafern.

Der erfindungsgemäß hergestellte Transistor mit der partiell-einkristallinen Emitterschicht 5 und das Verfahren zu seiner Herstellung ermöglichen einen Einsatz in modernen SiₓGe_{y}C_{1-x-y} Technologien, mit den Parametern x,y im Bereich 0 ≤ x,y ≤ 1, die perspektivisch für die Fertigung von modernen hochintegrierten Schaltkreisen für mobile Kommunikation vorgesehen sind.

In der vorliegenden Erfindung wurde anhand konkreter Ausführungsbeispiele ein Verfahren zur Herstellung partiell-einkristalliner Emitterschichten 5 in Si / Si / SiₓGe_{y}C_{1-x-y}-Heterostrukturen, mit den Parametern x,y im Bereich 0 ≤ x,y ≤ 1, erläutert. Es sei jedoch vermerkt, daß die vorliegende Erfindung nicht auf die Einzelheiten der Beschreibung in den Ausführungsheispielen eingeschränkt ist, da im Rahmen der Patentansprüche Änderungen und Abwandlungen beansprucht werden.

## Patentansprüche

1. Verfahren zur Herstellung der Schichtstruktur für Si-basierende bipolare Transistoren auf einem Siliziumsubstrat, umfassend eine Halbleiterschicht und eine über der Halbleiterschicht gebildete Emitterschicht, wobei zwischen der Halbleiterschicht und der Emitterschicht (5) lokal dünne Oxid- und/oder Nitridschichten gebildet sind und die Emitterschicht (5) an die Halbleiterschicht angrenzend einen einkristallinen Bereich und, durch den einkristallinen Bereich von der Halbleiterschicht getrennt, einen polykristallinen oder amorphen Bereich aufweist, **dadurch gekennzeichnet, daß**
- eine Lagerung des Siliziumsubstrats nach einer Vorbehandlung einer Oberfläche des Siliziumsubstrats (1) mit hydrofluoridhaltigen Lösungsmitteln und vor einem Einschleusen in einen CVD-Reaktor auf weniger als eine Stunde begrenzt wird,
- eine Vortemperung des Siliziumsubstrats im Temperaturbereich von 650 °C - 1100 °C in wasserstoffhaltigen Gasen bei Temperzeiten im Bereich von 5 Sekunden bis 120 Minuten vorgesehen ist,
- ein Dotiergas bereits während einer Abkühlung auf eine Schichtwachstumstemperatur zugeführt wird und
- nach der Abkühlung auf die Schichtwachstumstemperatur eine partiell-einkristalline Emitterschicht (5) unter Zugabe von Silan und Dotiergas bei einer Temperatur im Bereich 450-700 °C aufgebracht wird, die zunächst einkristallin anwächst und dann in eine polykristalline und/oder amorphe Schicht umschlägt.

2. Verfahren nach Anspruch 1, **dadurch gekennzeichnet, daß** die partiell-einkristalline Emitterschicht (5) mittels chemischer Gasphasenabscheidung bei Niederdruck in einem Vielscheibenreaktor aufgebracht wird.

3. Verfahren nach Anspruch 1 oder 2, **dadurch gekennzeichnet, daß** die partiell-einkristalline Emitterschicht (5) durch eine dotierte SiₓGe_{y}C_{1-x-y}- Schicht (3) mit den Parametern x, y im Bereich 0 ≤x,y ≤1 gebildet wird.

4. Verfahren nach einem der Ansprüche 1 bis 3, **dadurch gekennzeichnet, daß** das Siliziumsubstrat ohne eine Belüftung der CVD-Anlage vor der Vortemperung in wasserstoffhaltigen Gasen einer intensiven Stickstoffspülung von mindestens 15 Minuten bei kaltem CVD-Reaktor unterzogen wird.

5. Verfahren nach einem der Ansprüche 1 bis 4, **dadurch gekennzeichnet, daß** die Halbleiterschicht der Transistoren zusätzlich mit einer SiₓGe_{y}C_{1-x-y} Deckelschicht (4), mit den Parametern x, y im Bereich 0 ≤ x, y ≤ 1, und mit einer Si-Pufferschicht (2) auf dem Siliziumsubstrat (1) hergestellt wird, und daß die Schichtstruktur nach einer Formierung der Deckelschicht (4) und vor dem Abscheiden der partiell-einkristallinen Emitterschicht (5) weiteren technologischen Teilschritten, wie beispielsweise Oxidationen, Implantationen, Ätzungen, Maskenteilschritten, unterzogen wird.

6. Verfahren nach einem der Ansprüche 1 bis 5, **dadurch gekennzeichnet, daß** als Dotierungselement für die partiell-einkristalline Emitterschicht (5) As und/oder P verwendet wird.

7. Verfahren nach einem der Ansprüche 1 bis 6, **dadurch gekennzeichnet, daß** wahlweise eine homogen dotierte partiell-einkristalline Emitterschicht (5) oder zur Erhöhung der Wachstumsrate dotierte und undotierte Bereiche der partiell- einkristallinen Emitterschicht (5) im Wechsel abgeschieden werden.

8. Verfahren nach einem der Ansprüche 1 bis 7, **dadurch gekennzeichnet, daß** die partiell-kristalline Emitterschicht (5) auf kommerziellen Si-Substratwafern oder auf kommerziellen "silicon-on-insulator" (SOI)-Wafern oder Si-Wafern mit homoepitaktischen Schichten und entsprechend dem Stand der Technik formierten Si- Basisstrukturen und Si-Kollektorstrukturen aufgebracht wird.

9. Verfahren nach einem der Ansprüche 1 bis 11, **dadurch gekennzeichnet, daß** die partiell-einkristalline Emitterschicht (5) als Si-Emitter in einer Heterostruktur Si-Emitter/Si/Si_{y}C_{1-y}/Si-Substrat zum Einsatz kommt.

10. Verfahren nach einem der Ansprüche 1 bis 8, **dadurch gekennzeichnet, daß** die partiell-kristalline Emitterschicht (5) als Si-Emitter in dreikomponentigen Materialsystemen der Art Si-Emitter/Si/SiₓGe_{y}C_{1-x-y}, Si-Emitter/Si/SiₓGe_{y}O_{1-x-y}, mit den Parametern x, y im Bereich 0 ≤x,y≤1, zum Einsatz kommt.

## Claims

1. Method for producing the layer structure for Si-based bipolar transistors on a silicon substrate, comprising a semiconductor layer and an emitter layer formed over the semiconductor layer, wherein locally thin oxide and/or nitride layers are formed between the semiconductor layer and the emitter layer (5), and the emitter layer (5) comprises, adjoining the semiconductor layer, a monocrystalline region and a polycrystalline or amorphous region separated from the semiconductor layer by the monocrystalline region, **characterised in that**
- storage of the silicon substrate after pre-treatment of a surface of the silicon substrate (1) with hydrofluoride-containing solvents and before locking into a CVD reactor is limited to less than one hour,
- pre-tempering of the silicon substrate is provided in the temperature range from 650 °C to 1100 °C in hydrogen-containing gases at tempering times in the range from 5 seconds to 120 minutes,
- a doping gas is supplied while cooling to a layer growth temperature, and
- after cooling to the layer growth temperature a partially monocrystalline emitter layer (5) is applied, with the addition of silane and doping gas, at a temperature in the range from 450 to 700 °C, this layer (5) initially growing in monocrystalline manner and then changing into a polycrystalline and/or amorphous layer.

2. Method according to claim 1, **characterised in that** the partially monocrystalline emitter layer (5) is applied by low pressure chemical vapour phase deposition in a multi-disc reactor.

3. Method according to claim 1 or claim 2, **characterised in that** the partially monocrystalline emitter layer (5) is formed by a doped SiₓGe_{y}C_{1-x-y}- layer (3) with the parameters x, y in the range 0 ≤ x, y ≤ 1.

4. Method according to one of claims 1 to 3, **characterised in that** before the pre-tempering in hydrogen-containing gases the silicon substrate is subjected to an intensive nitrogen flushing for at least 15 minutes in the cold CVD reactor without any venting of the CVD apparatus.

5. Method according to one of claims 1 to 4, **characterised in that** the semiconductor layer of the transistors is additionally produced with a SiₓGe_{y}C_{1-x-y}-covering layer (4), with the parameters x, y in the range 0 ≤ x, y ≤ 1, and with an Si buffer layer (2) on the silicon substrate (1), and **in that** the layer structure is subjected to further technological partial steps such as for example oxidations, implantations, etching, partial masking steps, after the forming of the covering layer (4) and before the deposition of the partially monocrystalline emitter layer (5).

6. Method according to one of claims 1 to 5, **characterised in that** As and/or P is used as the doping element for the partially monocrystalline emitter layer (5).

7. Method according to one of claims 1 to 6, **characterised in that** a homogeneously doped partially monocrystalline emitter layer (5) or, to increase the growth rate, doped and undoped regions of the partially monocrystalline emitter layer (5) are selectively deposited alternately.

8. Method according to one of claims 1 to 7, **characterised in that** the partially crystalline emitter layer (5) is applied to commercial Si substrate wafers or to commercial "silicon-on-insulator" (SOI) wafers or Si wafers with homoepitaxial layers and Si base structures and Si collector structures formed according to the prior art.

9. Method according to one of claims 1 to 11, **characterised in that** the partially crystalline emitter layer (5) is used as an Si emitter in an Si emitter/Si/Si_{y}C_{1-y}/Si substrate heterostructure.

10. Method according to one of claims 1 to 8, **characterised in that** the partially crystalline emitter layer (5) is used as an Si emitter in three-component material systems of the Si emitter/Si/SiₓGe_{y}C_{1-x-y}, Si emitter/Si/SiₓGe_{y}O_{1-x-y} type, with the parameters x, y in the range 0 ≤ x, y ≤ 1.

## Revendications

1. Procédé de production d'une structure stratifiée pour transistors bipolaires à base de Si sur un substrat de silicium, comprenant une couche semi-conductrice et une couche formant émetteur formée sur la couche semi-conductrice, dans lequel, entre la couche semi-conductrice et la couche formant émetteur (5) sont formées localement de fines couches d'oxyde et/ou de nitrure et la couche formant émetteur (5) présente, adjacent à la couche semi-conductrice une zone monocristalline et, séparée par la zone monocristalline de la couche semi-conductrice, une zone polycristalline ou amorphe, **caractérisé en ce que**
- un stockage du substrat de silicium après un prétraitement d'une surface du substrat de silicium (1) est limité à moins d'une heure avec des solvants contenant des hydrofluorures et par une introduction dans un réacteur de dépôt chimique en phase vapeur (CVD),
- un pré-trempage du substrat de silicium dans une plage de température de 650° C à 1100° C dans des gaz contenant de l'hydrogène à des temps de trempage de l'ordre de 5 secondes à 120 minutes est prévu,
- un gaz de dopage est déjà acheminé pendant un refroidissement à une température de croissance de couche et
- après le refroidissement à la température de croissance de couche, une couche formant émetteur partiellement cristalline (5) est appliquée en ajoutant du silane et un gaz de dopage à une température dans une plage de 450 à 700° C, qui se développe tout d'abord sous forme monocristalline et ensuite passe à une couche polycristalline et/ou amorphe.

2. Procédé selon la revendication 1, **caractérisé en ce que** la couche formant émetteur partiellement cristalline (5) est appliquée par dépôt en phase gazeuse chimique à une basse pression dans un réacteur à disque multiples.

3. Procédé selon la revendication 1 ou 2, **caractérisé en ce que** la couche formant émetteur partiellement monocristalline (5) est formée par une couche dopée de SiₓGe_{y}C_{1-x-y}- (3), les paramètres x, y étant dans l'intervalle de 0 ≤ x, y ≤ 1.

4. Procédé selon l'une des revendications 1 à 3, **caractérisé en ce que** le substrat de silicium sans aération de l'installation CVC avant le pré-trempage dans des gaz contenant de l'hydrogène est soumis à un rinçage intensif à l'azote pendant au moins 15 minutes dans le réacteur CVD froid.

5. Procédé selon l'une des revendications 1 à 4, **caractérisé en ce que** la couche semi-conductrice des transistors est produite en outre avec une couche de revêtement (4) de SiₓGe_{y}C_{1-x-y}- (4), les paramètres x, y étant dans l'intervalle de 0 ≤ x, y ≤ 1, et avec une couche tampon de Si (2) sur le substrat de silicium (1) et **en ce que** la structure en couches est soumise après une mise en forme de la couche de revêtement (4) et avant le dépôt de la couche formant émetteur partiellement monocristalline (5) à d'autres étapes techniques partielles telles que par exemple des oxydations, implantations, corrosions, masquages partiels.

6. Procédé selon l'une des revendications 1 à 5, **caractérisé en ce que** l'on utilise comme élément de dopage pour la couche formant émetteur partiellement monocristalline (5) de l'As et/ou du P.

7. Procédé selon l'une des revendications 1 à 6, **caractérisé en ce que** sont déposées alternativement au choix une couche formant émetteur partiellement monocristalline dopée de façon homogène (5) ou des zones dopées et non dopées de la couche formant émetteur partiellement monocristalline (5) pour augmenter le taux de croissance.

8. Procédé selon l'une des revendications 1 à 7, **caractérisé en ce que** la couche formant émetteur partiellement monocristalline (5) est appliquée sur des plaquettes de substrat de Si du commerce ou sur des plaquettes de "silicium sur isolant" (SOI) du commerce ou des plaquettes de Si avec des couches homo-épitactiques et des structures de base en Si et des structures de collecteur en Si formées selon l'état de la technique.

9. Procédé selon l'une des revendications 1 à 11, **caractérisé en ce que** la couche formant émetteur partiellement monocristalline (5) est utilisée comme émetteur en Si dans une hétérostructure d'émetteur en Si/Si/ Si_{y}C_{1-y}.

10. Procédé selon l'une des revendications 1 à 8, **caractérisé en ce que** la couche formant émetteur partiellement cristalline (5) est utilisée comme émetteur en Si dans des systèmes de matériaux à trois composants du type émetteur en Si/Si/SiₓGe_{y}C_{1-x-y}, émetteur en Si/Si/SiₓGe_{y}O_{1-x-y} les paramètres x, y étant dans l'intervalle de 0 ≤ x, y ≤ 1.
